# EUROPEAN PATENT SPECIFICATION

(11) **EP 2 508 655 B1**
(45) Date of publication and mention of the grant of the patent: **18.02.2015**
(21) Application number: 10832998.8
(22) Date of filing: 18.10.2010
(51) Int. Cl.: C30B 29/36, C30B 23/00, C30B 23/02

(54) **METHOD OF PRODUCING SILICON CARBIDE MONOCRYSTALS**
VERFAHREN ZUR HERSTELLUNG EINES SILICIUMCARBIDEINZELKRISTALLS
PROCÉDÉ DE PRODUCTION DE MONOCRISTAUX DE CARBURE DE SILICIUM

(30) Priority: 30.11.2009 JP 2009271712
(43) Date of publication of application: 10.10.2012
(73) Proprietor: Showa Denko K.K., Tokyo 105-8518 (JP)
(72) Inventor: MASUDA Takashi, Chichibu-shi Saitama 369-1893 (JP); KOGOI Hisao, Chichibu-shi Saitama 369-1893 (JP); HASHIMOTO Katsuhiko, Chichibu-shi Saitama 369-1893 (JP)
(74) Representative: Strehl Schübel-Hopf & Partner
(86) International application number: PCT/JP2010/068271
(87) International publication number: WO 2011/065151

(56) References cited:
- JP-A- 2003 504 297
- JP-A- 2006 143 511
- JP-A- 2007 326 743
- US-A1- 2002 083 892

## Description

### TECHNICAL FIELD

The present invention relates to a process for producing silicon carbide single crystals. More particularly, the present invention relates to a process for producing silicon carbide single crystals by supplying a sublimed gas of a silicon carbide source material and growing single crystals of silicon carbide on a silicon carbide seed crystal.

The present application claims priority on the basis of Japanese Patent Application No. 2009-271712 filed in Japan on November 30, 2009, the contents of which are incorporated herein by reference.

### BACKGROUND ART

In addition to having high thermal conductivity, having superior heat resistance and mechanical strength, and being physically and chemically stable, including being resistant to radiation, silicon carbide also has the characteristic of having a wide energy band gap (forbidden band width). Consequently, it is expected to be applied in applications including light emitting elements, large electrical power devices, high temperature-resistant elements,

radiation-resistant elements and high-frequency elements.

A known example of a process for producing silicon carbide single crystals consists of arranging a silicon carbide seed crystal on a pedestal, supplying a sublimed gas of a silicon carbide source material, and growing single crystals of silicon carbide on the silicon carbide seed crystal. Known examples of methods used to hold the silicon carbide single crystals on the pedestal include a method in which the silicon carbide seed crystal is affixed to the pedestal by adhering using an adhesive (Patent Document 1), and a method in which the silicon carbide seed crystal is mechanically supported on the pedestal without affixing using an adhesive (Patent Document 2).

Furthermore, in JP2006143511 it is taught to adhere a first silicon carbide substrate on the surface of the seed crystal supporting part of a covering body via an adhesive,adhering a second silicon carbide substrate as the seed crystal on the first silicon carbide substrate via an adhesive and growing silicon carbide single crystal.

### [Prior Art Documents]

### [Patent Documents]

[Patent Document 1]
   Japanese Unexamined Patent Application, First Publication No. 2009-120419
[Patent Document 2]
   Japanese Patent Publication No. 4275308

### DISCLOSURE OF THE INVENTION

### [Problems to be Solved by the Invention]

However, in the method in which a silicon carbide seed crystal is affixed to a pedestal by adhering using an adhesive, the silicon carbide seed crystal is subjected to thermal stress from the pedestal based on a difference in their respective coefficients of thermal expansion, and since this ends up imparting strain to the silicon carbide seed crystal, the silicon carbide single crystals grown thereon also have strain, resulting in the problem of causing the formation of cracks. In addition, in the method in which a silicon carbide seed crystal is mechanically supported on a pedestal, polycrystals grow between the supporting member and the seed crystal, and since these polycrystals grow so as to cover the outer periphery of single crystals, the polycrystals impart stress to the silicon carbide single crystals, thereby resulting in the problem of generating strain.

In consideration of the aforementioned circumstances, an object of the present invention is to provide a process for producing silicon carbide single crystals that allows the production of strain-free, high-quality silicon carbide single crystals since contact by polycrystals grown on a supporting member with silicon carbide single crystals is avoided during growth thereof, and there is no stress applied to the silicon carbide single crystals from a pedestal.

### [Means for Solving the Problems]

The present invention provides the means indicated below.
(1) A process for producing silicon carbide single crystals, including: a step for growing single crystals of silicon carbide on a silicon carbide seed crystal by supplying a sublimed gas of a silicon carbide source material to the silicon carbide seed crystal arranged on a pedestal; wherein,
   a spacing member composed of silicon carbide is arranged between the pedestal and the silicon carbide seed crystal,
   the spacing member is non-adhesively held on the pedestal by a supporting member,
   the silicon carbide seed crystal is adhered to the surface of the spacing member on the opposite side of the pedestal, and
   the spacing member and the supporting member are relatively arranged so that the adhesive surface of the spacing member adhered with the silicon carbide seed crystal is separated by 5 mm or more in the vertical direction from the lowest position of the supporting member.
   Here, the phrase "the spacing member is non-adhesively held on the pedestal by a supporting member" includes the case of the spacing member contacting the pedestal and the case of the spacing member being arranged at a distance from the pedestal without making contact therewith.
(2) The process for producing silicon carbide single crystals described in (1) above, wherein the adhesive surface of the spacing member is subjected to curvature processing to match the warped shape of the silicon carbide seed crystal.
   Here, the "curvature" of "curvature processing" refers to the curvature when "warp" is expressed as radius of curvature or curvature.
(3) The process for producing silicon carbide single crystals described in (1) or (2) above, wherein the difference in the amount of warp between the spacing member and the silicon carbide seed crystal is ±5 µm or less.
   Here, the "amount of warp" refers to the height thereof when "warp" is expressed as the height from a flat surface. Namely, the "amount of warp" refers to the distance from a flat surface to the apex (highest point) of a protrusion of the spacing member or silicon carbide seed crystal when a warped spacing member or silicon carbide seed crystal is placed on the flat surface with the warped protrusion side facing upward.
(4) The process for producing silicon carbide single crystals described in any of (1) to (3) above, wherein the spacing member is formed with any of polycrystals, single crystals or sintered compact.
(5) The process for producing silicon carbide single crystals described in any of (1) to (4) above, wherein the spacing member is composed of a plurality of layers.
(6) The process for producing silicon carbide single crystals described in (5) above, wherein buffering layers are provided between the plurality of layers.
(7) The process for producing silicon carbide single crystals described in any of (1) to (6) above, wherein
   the spacing member is provided with a support holder around the outer periphery thereof,
   the supporting member is provided with a hook on the lower portion thereof, and
   the support holder of the spacing member is supported by the hook of the supporting member.
(8) The process for producing silicon carbide single crystals described in any of (1) to (7) above, wherein
   internal threads are formed in the inner periphery of the supporting member,
   external threads that engage with the internal threads are formed on the outer periphery of the pedestal, and
   spacing between the pedestal and the spacing member can be adjusted by relatively rotating the supporting member and/or the pedestal.
(9) The process for producing silicon carbide single crystals described in any of (1) to (8) above, wherein the supporting member is composed of graphite.
(10) The process for producing silicon carbide single crystals described in any of (1) to (9) above, wherein a buffering member is provided between the pedestal and the spacing member.
(11) The process for producing silicon carbide single crystals described in (10) above, wherein the buffering member is composed of grafoil, carbon felt or a high melting point metal.

### [Effects of the Invention]

According to the aforementioned configuration, a process for producing silicon carbide single crystals can be provided that allows the production of strain-free, high-quality silicon carbide single crystals without being affected by polycrystals.

### BRIEF DESCRIPTION OF THE DRAWINGS

FIG. 1 is a cross-sectional schematic diagram showing an example of a silicon carbide single crystal growth device.
FIG. 2 is an enlarged cross-sectional schematic diagram of the vicinity of a pedestal.
FIG. 3 is an enlarged cross-sectional schematic diagram of the vicinity of a pedestal during growth of silicon carbide single crystals on a silicon carbide seed crystal.
FIG. 4 is an enlarged cross-sectional schematic diagram of a contact portion of a pedestal and a supporting member.

### EMBODIMENTS OF THE INVENTION

The following provides a detailed explanation of a process for producing silicon carbide single crystals as an embodiment to which the present invention is applied with reference to the drawings. Furthermore, the drawings used in the explanation may contain enlarged portions characteristic to the present invention for the sake of convenience to facilitate understanding of those characteristics, and the dimensional proportions and the like of each constituent are not necessarily reflective of actual dimensions.

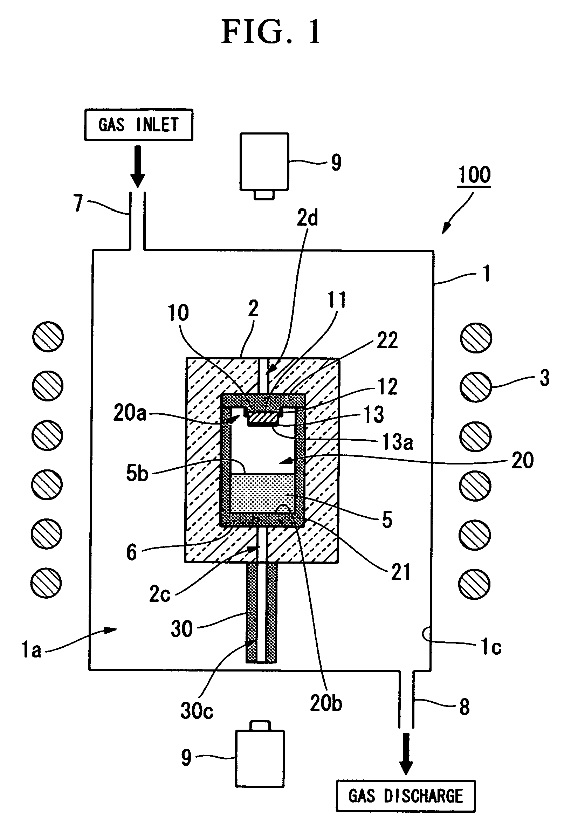

FIG. 1 is a drawing for explaining the process for producing silicon carbide single crystals as an embodiment of the present invention, and is a cross-sectional schematic diagram showing an example of a silicon carbide single crystal growth device.

As shown in FIG. 1, a silicon carbide single crystal growth device 100 is roughly composed of a vacuum vessel 1, a crucible 6 arranged inside the vacuum vessel 1, and heating coils 3 arranged surrounding the vacuum vessel 1.

In the process for producing silicon carbide single crystals of the present invention, a spacing member 11 composed of silicon carbide is arranged between a pedestal 10 and a silicon carbide seed crystal 13, the spacing member 11 is non-adhesively held on the pedestal 10 by a supporting member 12, the silicon carbide seed crystal 13 is adhered to a surface 11b of the spacing member 11 on the opposite side of the pedestal 10, and silicon carbide single crystals are grown by relatively arranging the spacing member 11 and the supporting member 12 so that the adhesive surface 11b with the silicon carbide seed crystal 13 of the spacing member 11 is separated by 5 mm or more in the vertical direction from a lowest position 15 of the supporting member 12.

The vacuum vessel 1 has a housing 1a in which the crucible 6 therein is arranged at a distance from an inner wall 1c, and an intake tube 7 and evacuation tube 8 are connected to the housing 1a. An arbitrary gas can be introduced to and discharged from the housing 1a by means of the intake tube 7 and the exhaust tube 8. A turbo molecular pump or other vacuum pump (not shown) is attached to the exhaust tube 8 that is able to generate high vacuum by evacuating air inside the housing 1 from the evacuation tube 8. For example, after having attained a state of reduced pressure within the housing 1a by evacuating air inside from the evacuation tube 8, highly pure argon (Ar) gas is supplied to the housing 1a from the intake tube 7, and as a result of again creating a state of reduced pressure, a state of reduced pressure of an argon (Ar) atmosphere can be created within the housing 1a.

Furthermore, the gas introduced into the vacuum vessel 1 is preferably an inert gas such as argon (Ar) gas or helium (He) gas, or nitrogen (N₂) gas. These gases do not cause a significant reaction with silicon carbide and demonstrate the effect of a coolant.

The heating coils 3 are arranged around the outer periphery of the vacuum vessel 1. The vacuum vessel 1, and in turn the crucible 6, can be heated by heating the heating coils 3.

The temperature of the silicon carbide seed crystal in the crucible 6 can be held at a temperature lower than the silicon carbide source material powder by adjusting the power of a heating device.

A thermal insulating material 2 is wrapped around the crucible 6 so as to cover the entire crucible 6. The thermal insulating material 2 is for stably maintaining the crucible 6 at a high temperature. The thermal insulating material 2 is not required to be provided in the case the crucible 6 can be stably maintained at a high temperature.

Holes 2c and 2d are formed in the thermal insulating material 2 so as to expose a portion of the lower and upper surfaces of the crucible 6. In addition, a supporting rod 30 provided with a hole 30c is arranged on the lower surface of the thermal insulating material 2. The hole 30c and the hole 2c are continuous, and the surface temperature of the crucible 6 can be measured with a radiation thermometer 9 arranged outside the vacuum vessel 1.

Furthermore, the surface temperature of the crucible 6 may also be measured by inserting thermocouples into the holes 2c and 2d and contacting the ends of the thermocouples with the surface of the crucible 6.

As shown in FIG. 1, the crucible 6 is composed of a body 21 and a seed crystal holding member (lid) 22. The body 21 has a cylindrical shape (not shown), and a cavity 20 formed by hollowing out the inside of the body 21 to a cylindrical shape.

A silicon carbide powder 5 is filled into the side of a bottom surface 20b of the cavity 20. In addition, a space required for growing silicon carbide single crystal ingots is secured on the side of an opening 20a of the cavity 20.

One side of the seed crystal holding member (lid) 22 protrudes cylindrically from the center thereof to form the pedestal 10. When the body 21 is covered with the seed crystal holding member (lid) 22, the pedestal 10 protrudes toward the bottom surface 20b in the upper portion of the cavity 20. The silicon carbide seed crystal 13 is held on the pedestal 10 by means of the spacing member 11 composed of silicon carbide. Since the silicon carbide seed crystal 13 does not make direct contact with the pedestal 10, the silicon carbide seed crystal is not subjected to thermal stress from the pedestal 10 based on a difference in coefficients of thermal expansion between the silicon carbide seed crystal 13 and the pedestal 10. On the other hand, together with being composed of silicon carbide, the spacing member 11 contacts the silicon carbide seed crystal 13 through an adhesive 14. Accordingly, thermal stress acting on the silicon carbide seed crystal 13 is based on a difference in coefficients of thermal expansion between the silicon carbide seed crystal 13 and the spacing member 11, and the value thereof is smaller than the value of thermal stress generated in the case of a configuration in which the silicon carbide seed crystal 13 and the pedestal 10 are in direct contact.

Similar effects are obtained whether the spacing member 11 composed of silicon carbide is in the form of polycrystals, single crystals or a sintered compact since the coefficients of thermal expansion thereof are equal. In addition, the spacing member 11 may also be composed of a plurality of layers, namely a plurality of layers of materials (such as single crystals, polycrystals or sintered compacts) having coefficients of thermal expansion equal to that of silicon carbide seed crystal. At this time, buffering layers formed from a material having low thermal conductivity may be interposed between the layers. The interposition of material layers having low thermal conductivity between each layer makes it possible to form a uniform temperature gradient in the seed crystal. In addition, the use of a silicon carbide material having a coefficient of thermal expansion equal to that of the silicon carbide seed crystal for the plurality of layers inhibits thermal stress from acting on the seed crystal by eliminating the difference in coefficients of thermal expansion there between.

Grafoil or carbon felt is preferable for the material of the buffering layers.

A plate-shaped seed crystal is used for the silicon carbide seed crystal 13, which is obtained by cutting a cylindrical silicon carbide single crystal produced by the Acheson method, Lely method or sublimation method and the like in a radial direction to a thickness of, for example, about 0.3 mm to 2 mm, followed by polishing the cut surface and molding into the shape of a plate. Furthermore, finishing treatment in the form of sacrificial oxidation, reactive ion etching or chemical mechanical polishing is preferably carried out on the seed crystal 13 to eliminate polishing damage following this polishing. Moreover, the surface of the seed crystal 13 is preferably subsequently cleaned using an organic solvent, acidic solvent or alkaline solvent and the like.

A known adhesive can be used for the adhesive 14, an example of which is a phenol-based resin.

A material that is stable at high temperatures and generates only a small amount of impurity gas is preferably used for the material of the body 21 of the crucible 6, and a material such as graphite, silicon carbide or graphite coated with silicon carbide or TaC is used preferably.

The seed crystal holding member (lid) 22 is preferably at least composed of any of graphite, amorphous carbon, carbon fiber, organic compound carbides or metal carbides. The seed crystal holding member 22 formed from these materials can be easily removed using a chemical method.

Furthermore, although the entire lid is used for the seed crystal holding member 22 in the present embodiment, a configuration may also be employed in which the lid is divided into the pedestal 10 and a portion other than the protruding portion, and only the pedestal 10 serves as the seed crystal holding member 22. The use of this configuration makes it possible to separate the portion other than the pedestal 10 and the finished product in the form of the silicon carbide single crystal ingot by removing the seed crystal holding member 22 even in the case the portion other than the pedestal 10 is not removed when removing the seed crystal holding member 22 after producing the silicon carbide single crystal ingot.

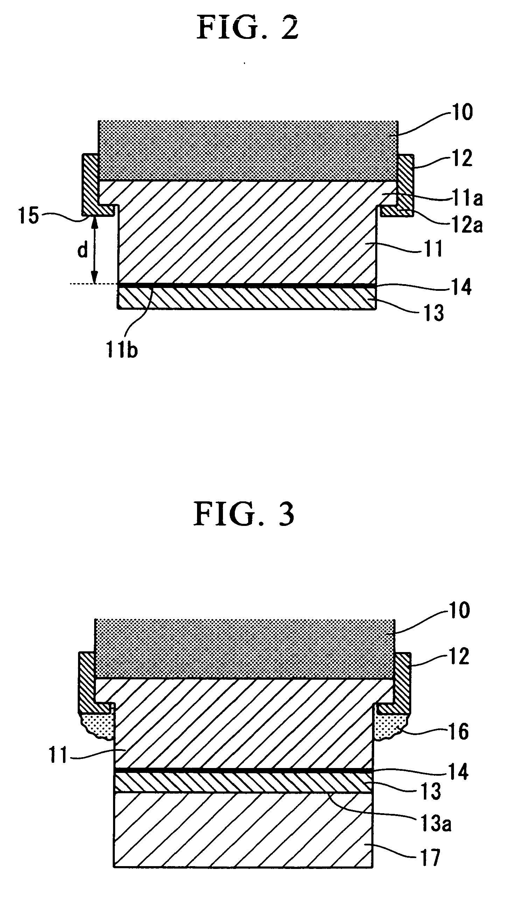

FIG. 2 shows an enlarged cross-sectional schematic diagram of the vicinity of the pedestal 10.

The spacing member 11 composed of silicon carbide is non-adhesively (without using adhesive) and mechanically held on the pedestal 10 by the supporting member 12. More specifically, the spacing member 11 is provided with a support holder 11a around the outer periphery thereof, while on the other hand, a hook 12a bent to the inside in the shape of the letter L, for example, is provided on the lower portion of the supporting member 12, and the holder 11a of the spacing member 11 is supported by the hook 12a of the supporting member 12.

The supporting member 12 is preferably composed of graphite.

The silicon carbide seed crystal 13 is adhered to the surface 11b of the spacing member 11 by the adhesive 14. The surface 11b is preferably subjected to curvature processing to match the warped shape of the silicon carbide seed crystal 13. Moreover, the difference in the amount of warp between the spacing member 11 and the silicon carbide seed crystal 13 is preferably ±5 µm or less.

Curvature processing can be carried out on the surface 11b by, for example, imparting a cylindrically convex shape or concave shape to the surface by turning process.

In this manner, the spacing member 11 having a preferable surface 11b can be fabricated by measuring the warp of the silicon carbide seed crystal 13 with, for example, a Newton ring or laser scanning, and then processing the surface 11b by turning process so as to correspond to that warped shape.

The spacing member 11 has a thickness such that a distance d from the surface 11b thereof to a lowest position 15 of the supporting member 12 is 5 mm or more in the vertical direction. As a result of making the surface 11b and the lowest position 15 of the supporting member 12 to be separated by 5 mm or more, as shown in FIG. 3, polycrystals 16 do not reach a growth surface 13a of the silicon carbide seed crystal 13 even if the polycrystals 16 grow between the supporting member 12 and the spacing member 11. In addition, strain is also not imparted by impairing growth of silicon carbide single crystals 17 on the silicon carbide seed crystal 13. In this manner, the present invention employs a configuration in which the polycrystals 16, which end up growing between the supporting member 12 and the spacing member 11, and the silicon carbide single crystals 17, which grow on the silicon carbide seed crystal 13, are completely isolated.

A buffering member may be provided between the pedestal 10 and the spacing member 11. The buffering member is preferably composed of grafoil, carbon felt or a high melting point metal.

Since grafoil and carbon felt are flexible graphite sheets, they are able to demonstrate buffering effects without applying stress to the seed crystal. In addition, a high melting point metal is able to prevent reaction between the pedestal and the spacing member.

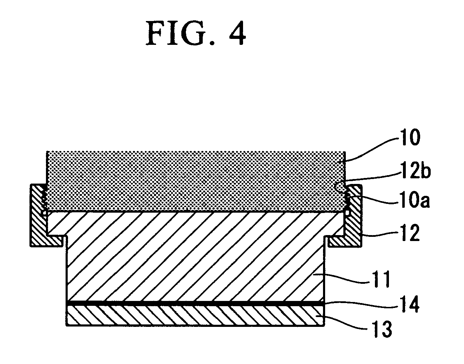

FIG. 4 shows an enlarged cross-sectional schematic diagram of a contact portion of the pedestal 10 and the supporting member 12.

As shown in FIG. 4, internal threads 12b may be formed in the inner periphery of the supporting member 12, and external threads 10a that engage with the internal threads 12b may be formed on the outer periphery of the pedestal 10. The use of these threaded structures makes it possible to adjust the spacing between the pedestal 10 and the spacing member 11 by rotating the supporting member 12 relative to the pedestal 10. In addition, a configuration may also be used in which the spacing between the pedestal 10 and the spacing member 11 is adjusted by rotating the pedestal 10, or by rotating both the supporting member 12 and the pedestal 10.

Production of silicon carbide single crystals is carried out, for example, in the manner described below.

A silicon carbide source material powder is heated to a temperature of 2400°C to 2500°C using a silicon carbide single crystal growth device configured in the manner described above. A temperature gradient is provided within the crucible so that the temperature of the silicon carbide seed crystal is lower than the temperature of the silicon carbide source material powder by, for example, adjusting a heating device. Next, when sublimation growth is initiated after setting the pressure within the crucible to 1 Torr to 30 Torr, the silicon carbide source material powder sublimes to produce a sublimed gas that reaches a silicon carbide seed crystal plate. As a result, silicon carbide single crystals grow on the surface of the silicon carbide seed crystal that is at a lower temperature relative to the side of the silicon carbide source material powder.

At this time, polycrystals of silicon carbide also grow on a supporting member that supports a spacing member composed of silicon carbide. However, since an adequate distance is maintained between silicon carbide seed crystal and the supporting member by the spacing member, single crystal growth of silicon carbide is not affected by the polycrystals of silicon carbide. In addition, since the pedestal and the spacing member are not adhered using an adhesive and the spacing member and the silicon carbide seed crystal have nearly the same coefficients of thermal expansion, stress acting on the silicon carbide seed crystal 13 is adequately relieved. As a result, silicon carbide single crystals can be produced that are free of cracks and of high quality.

### [Examples]

Silicon carbide single crystals were grown using the silicon carbide single crystal growth device shown in FIGS. 1 and 2.

A silicon carbide single crystal wafer having a diameter of 76 mm (3 inch φ) and thickness of 0.8 mm was used for the seed crystal, and a silicon carbide single crystalline substance having a thickness of 8 mm was used for the spacing member. The spacing member and seed crystal were adhered using a carbon paste for the adhesive.

A silicon carbide source material powder was heated to a temperature of 2450°C, a temperature gradient was provided within the crucible so that the temperature of the silicon carbide seed crystal was lower than the temperature of the silicon carbide source material powder by adjusting a heating device, for example, and the temperature of the seed crystal was made to be 2250°C. Next, the pressure within the crucible was set to 3 Torr and crystal growth was carried out at a growth rate of 0.5 mm/H.

Crystal growth was carried out under ordinarily used conditions in this manner to form silicon carbide single crystals having a thickness of 20 mm.

Polycrystals grown separately at the growth of the silicon carbide single crystals (polycrystals 16 schematically shown in FIG. 3) had a length of 3 mm extending downward from the lowest position of the supporting member.

However, since the spacing member having a thickness of 8 mm was interposed between the pedestal and seed crystal, the polycrystals that grew did not reach the seed crystal, the crystals that grew were completely isolated from the polycrystals, and cracks did not form.

### INDUSTRIAL APPLICABILITY

The process for producing silicon carbide single crystals of the present invention can be used to produce strain-free, high-quality silicon carbide single crystals.

### BRIEF DESCRIPTION OF THE REFERENCE SYMBOLS

- 10: Pedestal
- 10a: External threads
- 11: Spacing member
- 11a: Support holder
- 12: Supporting member
- 12a: Hook
- 12b: Internal threads
- 13: Silicon carbide seed crystal
- 14: Adhesive
- 15: Lowest position
- 16: Polycrystals
- 17: Silicon carbide single crystals

## Claims

1. A process for producing silicon carbide single crystals, comprising: a step for growing single crystals of silicon carbide on a silicon carbide seed crystal by supplying a sublimed gas of a silicon carbide source material to the silicon carbide seed crystal arranged on a pedestal; wherein,
a spacing member composed of silicon carbide is arranged between the pedestal and the silicon carbide seed crystal,
the spacing member is non-adhesively held on the pedestal by a supporting member,
the silicon carbide seed crystal is adhered to the surface of the spacing member on the opposite side of the pedestal, and
the spacing member and the supporting member are relatively arranged so that the adhesive surface of the spacing member adhered with the silicon carbide seed crystal is separated by 5 mm or more in the vertical direction from the lowest position of the supporting member.

2. The process for producing silicon carbide single crystals according to claim 1, wherein the adhesive surface of the spacing member is subjected to curvature processing to match the warped shape of the silicon carbide seed crystal.

3. The process for producing silicon carbide single crystals according to claim 1, wherein the difference in the amount of warp between the spacing member and the silicon carbide seed crystal is ±5 µm or less.

4. The process for producing silicon carbide single crystals according to claim 1, wherein the spacing member is formed with any of polycrystals, single crystals or sintered compact.

5. The process for producing silicon carbide single crystals according to claim 1, wherein the spacing member is composed of a plurality of layers.

6. The process for producing silicon carbide single crystals according to claim 5, wherein buffering layers are provided between the plurality of layers.

7. The process for producing silicon carbide single crystals according to claim 1, wherein
the spacing member is provided with a support holder around the outer periphery thereof,
the supporting member is provided with a hook on the lower portion thereof, and
the support holder of the spacing member is supported by the hook of the supporting member.

8. The process for producing silicon carbide single crystals according to claim 1, wherein
internal threads are formed in the inner periphery of the supporting member,
external threads that engage with the internal threads are formed on the outer periphery of the pedestal, and
spacing between the pedestal and the spacing member can be adjusted by relatively rotating the supporting member and/or the pedestal.

9. The process for producing silicon carbide single crystals according to claim 1, wherein the supporting member is composed of graphite.

10. The process for producing silicon carbide single crystals according to claim 1, wherein a buffering member is provided between the pedestal and the spacing member.

11. The process for producing silicon carbide single crystals according to claim 10, wherein the buffering member is composed of grafoil, carbon felt or a high melting point metal.

## Patentansprüche

1. Verfahren zum Herstellen von Siliciumcarbideinkristallen, welches umfasst: eine Stufe, in der Einkristalle von Siliciumcarbid auf einem Siliciumcarbidkeimkristall gezüchtet werden, indem ein sublimiertes Gas eines Siliciumcarbidausgangsmaterials zu dem auf einem Sockel angeordneten Siliciumcarbidkeimkristall gegeben wird; wobei ein aus Siliciumcarbid zusammengesetztes Abstandselement zwischen dem Sockel und dem Siliciumcarbidkeimkristall angeordnet ist, das Abstandselement nicht verklebend durch ein Stützelement auf dem Sockel gehalten wird, der Siliciumcarbidkeimkristall an die Oberfläche des Abstandselements auf der gegenüberliegenden Seite des Sockels geklebt wird und das Abstandselement und das Stützelement zueinander so angeordnet sind, dass die klebrige Oberfläche des mit dem Siliciumcarbidkeimkristall verklebten Abstandselements in vertikaler Richtung von der untersten Position des Stützelements 5 mm oder mehr getrennt ist.

2. Verfahren zum Herstellen von Siliciumcarbideinkristallen nach Anspruch 1, wobei die klebrige Oberfläche des Abstandselements einer Krümmungsbehandlung unterworfen wird, um mit der gekrümmten Oberfläche des Siliciumcarbidkeimkristalls übereinzustimmen.

3. Verfahren zum Herstellen von Siliciumcarbideinkristallen nach Anspruch 1, wobei der Unterschied in dem Ausmaß der Verformung zwischen dem Abstandselement und dem Siliciumcarbidkeimkristall ±5 µm oder weniger ist.

4. Verfahren zum Herstellen von Siliciumcarbideinkristallen nach Anspruch 1, wobei das Abstandselement beliebig mit Polykristallen, Einkristallen oder gesinterten Verbundstoffen gebildet ist.

5. Verfahren zum Herstellen von Siliciumcarbideinkristallen nach Anspruch 1, wobei das Abstandselement aus einer Vielzahl von Schichten zusammengesetzt ist.

6. Verfahren zum Herstellen von Siliciumcarbideinkristallen nach Anspruch 5, wobei die Pufferschichten zwischen der Vielzahl von Schichten angeordnet sind.

7. Verfahren zum Herstellen von Siliciumcarbideinkristallen nach Anspruch 1, wobei das Abstandselement mit einem Stützhalter um seinen äußeren Rand herum versehen ist, das Stützelement mit einem Haken auf seiner Unterseite versehen ist und der Stützhalter des Abstandselements durch den Haken des Stützelements gestützt wird.

8. Verfahren zum Herstellen von Siliciumcarbideinkristallen nach Anspruch 1, wobei innere Stränge in dem inneren Randbereich des Stützelements gebildet sind, äußere Stränge, die mit den inneren Strängen ineinander greifen, auf dem äußeren Randbereich des Sockels gebildet sind und der Abstand zwischen dem Sockel und dem Abstandselement durch Rotieren des Stützelements und/oder des Sockels in Bezug zueinander eingestellt werden kann.

9. Verfahren zum Herstellen von Siliciumcarbideinkristallen nach Anspruch 1, wobei das Stützelement aus Graphit zusammengesetzt ist.

10. Verfahren zum Herstellen von Siliciumcarbideinkristallen nach Anspruch 1, wobei das Pufferelement zwischen dem Sockel und dem Abstandselement angeordnet ist.

11. Verfahren zum Herstellen von Siliciumcarbideinkristallen nach Anspruch 10, wobei das Pufferelement aus Grafoil, Kohlenstofffilz oder einem Metall mit hohem Schmelzpunkt zusammengesetzt ist.

## Revendications

1. Procédé de production de monocristaux de carbure de silicium, comprenant :
une étape de croissance de monocristaux de carbure de silicium sur un cristal de germe de carbure de silicium par introduction d'un gaz sublimé d'un matériau de source de carbure de silicium sur le cristal de germe de carbure de silicium disposé sur une base ; dans lequel,
un élément d'écartement constitué de carbure de silicium est disposé entre la base et le cristal de germe de carbure de silicium,
l'élément d'écartement est maintenu de manière non adhésive sur la base par un élément de support,
le cristal de germe de carbure de silicium est collé sur la surface de l'élément d'écartement sur le côté opposé de la base, et
l'élément d'écartement et l'élément de support sont disposés relativement de sorte que la surface adhésive de l'élément d'écartement collée avec le cristal de germe de carbure de silicium est séparée de 5 mm ou plus dans la direction verticale à partir de la position la plus basse de l'élément de support.

2. Procédé de production de monocristaux de carbure de silicium selon la revendication 1, dans lequel la surface adhésive de l'élément d'écartement est soumise à un traitement de courbure pour s'adapter à la forme voilée du cristal de germe de carbure de silicium.

3. Procédé de production de monocristaux de carbure de silicium selon la revendication 1, dans lequel la différence de la quantité de voile entre l'élément d'écartement et le cristal de germe de carbure de silicium est de ± 5 µm ou inférieure.

4. Procédé de production de monocristaux de carbure de silicium selon la revendication 1, dans lequel l'élément d'écartement est formé avec l'un quelconque de polycristaux, monocristaux ou compact fritté.

5. Procédé de production de monocristaux de carbure de silicium selon la revendication 1, dans lequel l'élément d'écartement est constitué de plusieurs couches.

6. Procédé de production de monocristaux de carbure de silicium selon la revendication 5, dans lequel des couches tampons sont fournies entre les plusieurs couches.

7. Procédé de production de monocristaux de carbure de silicium selon la revendication 1, dans lequel
l'élément d'écartement est muni d'un dispositif de maintien de support autour de sa périphérie externe,
l'élément de support est muni d'un crochet sur sa partie inférieure, et
le dispositif de maintien de support de l'élément d'écartement est supporté par le crochet de l'élément de support.

8. Procédé de production de monocristaux de carbure de silicium selon la revendication 1, dans lequel
des fils internes sont formés dans la périphérie interne de l'élément de support,
des fils externes qui s'engrènent avec les fils internes sont formés sur la périphérie externe de la base, et
l'écartement entre la base et l'élément d'écartement peut être ajusté par rotation relative de l'élément de support et/ou de la base.

9. Procédé de production de monocristaux de carbure de silicium selon la revendication 1, dans lequel l'élément de support est constitué de graphite.

10. Procédé de production de monocristaux de carbure de silicium selon la revendication 1, dans lequel un élément tampon est fourni entre la base et l'élément d'écartement.

11. Procédé de production de monocristaux de carbure de silicium selon la revendication 10, dans lequel l'élément tampon est constitué de grafoil, de feutre de carbone ou d'un métal de point de fusion élevé.
